# EUROPEAN PATENT SPECIFICATION

(11) **EP 2 892 151 B1**
(45) Date of publication and mention of the grant of the patent: **31.07.2019**
(21) Application number: 13833128.5
(22) Date of filing: 05.06.2013
(51) Int. Cl.: H03H 7/01, H03H 7/46, H03H 9/46, H03H 9/70, H04B 1/50

(54) **FILTER DEVICE AND DUPLEXER**
FILTERVORRICHTUNG UND DUPLEXER
DISPOSITIF DE FILTRE ET DUPLEXEUR

(30) Priority: 30.08.2012 JP 2012189542
(43) Date of publication of application: 08.07.2015
(73) Proprietor: Murata Manufacturing Co., Ltd., Nagaokakyo-shi, Kyoto 617-8555 (JP)
(72) Inventor: KAWASAKI, Koichiro, Nagaokakyo-shi Kyoto 617-8555 (JP)
(74) Representative: Delumeau, François Guy
(86) International application number: PCT/JP2013/065583
(87) International publication number: WO 2014/034214

(56) References cited:
- JP-A- 2004 248 321
- JP-A- 2004 248 321
- JP-A- 2012 109 818
- JP-A- 2012 109 818
- US-A- 5 905 418
- US-A1- 2005 057 323
- US-A1- 2010 127 795
- US-A1- 2011 074 527
- US-A1- 2011 304 410
- HIMANSHU JOSHI ET AL: "Dual-Band Lumped-Element Bandpass Filter", IEEE TRANSACTIONS ON MICROWAVE THEORY AND TECHNIQUES, IEEE SERVICE CENTER, PISCATAWAY, NJ, US, vol. 54, no. 12, 1 December 2006 (2006-12-01), pages 4169-4177, XP011151486, ISSN: 0018-9480, DOI: 10.1109/TMTT.2006.885576

## Description

### Technical Field

The present invention relates to band pass filter devices and duplexers including the same.

### Background Art

To date, various band pass filters have been used in mobile communication apparatuses such as cellular phones. In cellular phone apparatuses, for example, frequency bands separating the pass bands of a plurality of channels have become narrower. Hence, it is strongly required that attenuation in the vicinity of the pass bands be increased.

Patent Document 1 below discloses a filter device in which a delay element is connected in parallel with a main filter. The characteristics of the delay element are set in such a manner that, at a desired frequency within the attenuated region of the main filter, the delay element has nearly the same amplitude characteristics as the main filter and has a phase which is different from that of the main filter by (2n-1)π (n is a positive integer). As a result, a direct wave at the desired frequency is cancelled out, and the attenuation at the desired frequency can be increased.

In Patent Document 1, the delay element described above is formed of, for example, a transversal SAW filter.

On the other hand, Patent Document 2 below discloses a filter device in which an auxiliary circuit is connected in parallel with a band pass filter. In the auxiliary circuit, a variable attenuator is connected in series with a variable phase shifter. The phase can be adjusted by the variable phase shifter. In the variable attenuator, the attenuation of a signal propagating through the auxiliary circuit can be adjusted.

### Citation List

### Patent Document

Patent Document 1: Japanese Unexamined Patent Application Publication No. 62-261211
Patent Document 2: Japanese Unexamined Patent Application Publication No. 10-256809

Other relevant prior art is mentioned as follows:
JP 2012 109818 A discloses a filter circuit including a filter part connected between an input terminal and an output terminal and configured to have a passband, and a path connected in parallel with the filter part between the input terminal and the output terminal, the path having an impedance that enables a first signal passing through the path from the input terminal to the output terminal and a second signal passing through the filter part from the input terminal to the output terminal to have an opposite phase relationship in a frequency band outside of the passband and have almost equal amplitudes in the frequency band.

JP 2004 248321 A provides a polar SAW filter with improved frequency characteristics. The polarized SAW filter has a two-terminal-pair SAW resonator type filter circuit having at least one serial arm SAW resonator and at least one parallel arm SAW resonator and a two-terminal-pair impedance circuit which is connected in parallel to the two-terminal-pair SAW resonator type filter circuit and has an impedance for forming an attenuation pole by equalizing the open impedance of the two-terminal-pair SAW resonator type filter circuit and the short-circuit impedance of the SAW filter.

In US 5905418 A, a surface-acoustic-wave filter couples a two-port surface-acoustic-wave resonator filter circuit coupled in parallel or in series with a two-port impedance circuit. The two-port impedance circuit has an impedance that creates a pole of attenuation, by making the open-circuit impedance of the surface-acoustic-wave filter equal to the short-circuit impedance. High attenuation over a wide range of stopband frequencies is obtained in this way, combined with steep roll-off between the passband and stopband.

US 2011/0304410 A discloses a filter circuit having two pass bands and including first and second bandpass filters which are connected in parallel with each other. Each of the bandpass filters includes at least a resonator group composed of a plurality of resonators arranged in orderly sequence so as to be coupled to each other to form a pass band, an input terminal coupled to a resonator on an input stage, and an output terminal coupled to a resonator on an output stage. The resonator group is composed of at least one of one or more quarter-wavelength resonators and one or more half-wavelength resonators. The resonator group of at least one of the first bandpass filter and the second bandpass filter includes both, one or more, quarter-wavelength resonators and one or more half-wavelength resonators.

US2011/0074527 A discloses a bandpass filter including three resonators of which adjacent two are electromagnetically coupled to each other, and two coupling paths connected in parallel for forming capacitive coupling between non-adjacent two of the resonators. Each of the two coupling paths includes at least one capacitor and an inductor connected in series. The two coupling paths function to form an attenuation pole at a frequency lower than the passband frequencies in the pass attenuation characteristics of the bandpass filter.

Another relevant prior art item is HIMANSHU JOSHI ET AL: "Dual-Band Lumped-Element Bandpass Filter", IEEE Trans. on Microwave Theory and Techniques, IEEE Service Center, PISCATAWAY, NJ, US, vol. 54, no. 12, 1 December 2006 (2006-12-01), pages 4169-4177, ISSN: 0018-9480. In this study, a dual-band lumped-element bandpass filter (DBLEF) is presented, which is implemented in low-temperature co-fired ceramic. The design utilizes the tight component coupling possible in this technology to mimic a much more complex network of lumped components. The filter is unique in that it utilizes only a single set of lumped components to create a dual-passband response. Detailed design equations are presented for the dual-band design, and a DBLEF having passbands at 2.4 and 5.2 GHz is demonstrated, representing the common wireless local area network bands.

US2005/057323 A discloses a boundary acoustic wave device including a first boundary acoustic wave element and a second boundary acoustic wave element disposed on the first boundary acoustic wave element. Each boundary acoustic wave element includes a first solid layer made of a piezoelectric material, a second solid layer made of one of a piezoelectric material and an insulating material and disposed on the first solid layer and a boundary acoustic wave exciting interdigital transducer arranged in the boundary between the first and second solid layers.

### Summary of Invention

### Technical Problem

As disclosed in Patent Document 1, when a signal flowing through a circuit that is connected in parallel with the filter and a signal flowing through the main filter have the same amplitude but opposite phases at a desired frequency, the attenuation can be made high at the desired frequency. Further, when the filter device disclosed in Patent Document 2 is used, by adjusting the adjustment amounts of the variable phase shifter and variable attenuation unit and the attenuation in the variable attenuation unit, the above-described condition, i.e., the same amplitude but opposite phases is satisfied.

However, active elements such as an IC and a diode are used in the auxiliary circuit including the variable phase shifter and variable attenuator disclosed in Patent Document 2. Hence, a control circuit is required, thereby making reductions in cost and size difficult. In addition, control currents for operating the active elements are needed, leading to the problem of high power consumption.

It is an object of the present invention to provide a filter device that allows a control circuit to be omitted and realizes a reduction in cost, a reduction in size, and a reduction in power consumption.

### Solution to Problem

A filter device according to the present invention has first and second signal terminals. The filter device of the present invention includes: a band pass filter connected between the first signal terminal and the second signal terminal; and an LC circuit connected between the first signal terminal and the second signal terminal, in parallel with the band pass filter. The LC circuit comprises an inductor and a capacitor connected in parallel to one another, and is configured to have anti-resonant characteristics with the anti-resonant frequency positioned within or in the vicinity of a pass band of the band pass filter so that almost no current flows through the LC circuit in the pass band of the band pass filter, and configured to make attenuation in a specified frequency band outside of the pass band of the band pass filter higher than in a case in which the LC circuit is not connected, as a result of the LC circuit being connected.

In a specific aspect of the filter device according to the present invention, in the specified frequency band outside of the pass band of the band pass filter, the amplitude characteristics and phase characteristics of the LC circuit and the amplitude characteristics and phase characteristics of the band pass filter have a relationship indicating the same amplitude within -3dB to 2dB of each other when compared on the basis of a log ratio but opposite phases or a phase difference within ±20 degrees of each other. In this case, the attenuation of the filter device can be effectively increased in the specified frequency band.

In another specific aspect of the filter device according to the present invention, said anti-resonant frequency of the LC circuit is positioned within the pass band of the band pass filter. In this case, a current flowing through the LC circuit becomes very small in the pass band of the band pass filter. Hence, there is almost no influence on the attenuation characteristics of the band pass filter in the pass band. In addition, power consumption can be further reduced.

In still another specific aspect of the filter device according to the present invention, the LC circuit is an LC circuit having a resonant frequency as well as an anti-resonant frequency. In the present invention, the LC circuit may be an LC circuit that does not have a resonant frequency.

A duplexer according to the present invention has an antenna terminal connected to an antenna. The duplexer includes a first filter device and a second filter device. The first filter device is formed of the filter device according to the present invention, where the first signal terminal is electrically connected to the antenna terminal. The second filter device is connected to the antenna terminal and has a pass band different from the pass band of the first filter device.

In a specific aspect of the duplexer according to the present invention, an anti-resonant frequency of the LC circuit in the first filter device is positioned between the pass band of the first filter device and the pass band of the second filter device. In this case, attenuation in a region between the pass band of the first filter device and the pass band of the second filter device can be effectively increased. Hence, the selectivity of the duplexer can be increased.

In another specific aspect of the duplexer according to the present invention, the first filter device is a transmission filter and the second filter device is a reception filter. In this case, the attenuation in a region between the transmission band and the reception band can be effectively increased.

### Advantageous Effects of Invention

In the filter device according to the present invention, since the LC circuit connected in parallel with the band pass filter is configured as described above, attenuation in a specified frequency band outside of the transmission band of the band pass filter can be increased. Further, since the LC circuit has anti-resonant characteristics that make the LC circuit be open in the pass band of the band pass filter, almost no current flows through the LC circuit in the pass band of the band pass filter. Hence, the attenuation in the specified frequencies outside of the pass band of the band pass filter can be increased without influencing attenuation characteristics in the pass band. In addition, no active elements are required for the LC circuit. Accordingly, a control circuit for controlling an active element can be omitted. Hence, reductions in size, cost, and power consumption can be realized.

### Brief Description of Drawings

Fig. 1 is a schematic block diagram illustrating a duplexer including a filter device according to a first embodiment of the present invention.
Fig. 2 is a diagram illustrating the attenuation-frequency characteristics of a transmission filter of the duplexer before an LC circuit is connected and the transmission characteristics of the LC circuit, in the first embodiment.
Fig. 3 is a diagram illustrating the attenuation-frequency characteristics of a filter device of the first embodiment, and the attenuation-frequency characteristics of the transmission filter of the duplexer to which the LC circuit is not connected.
Fig. 4 is a diagram illustrating the attenuation-frequency characteristics of the transmission filter of the duplexer before the LC circuit is connected and the transmission characteristics of the LC circuit, in the case where the measurement frequency band illustrated in Fig. 2 has been widened, in the first embodiment.
Fig. 5 is a schematic block diagram illustrating a duplexer including a filter device according to a second embodiment of the present invention.
Fig. 6 is a diagram illustrating the attenuation-frequency characteristics of a transmission filter of the duplexer used in the second embodiment of the present invention and the transmission characteristics of an LC circuit.
Fig. 7 is a diagram illustrating the attenuation-frequency characteristics of the transmission filter in the second embodiment and the attenuation-frequency characteristics of the transmission filter before the LC circuit is connected.
Fig. 8 is a schematic block diagram illustrating a filter device according to a third embodiment of the present invention.
Fig. 9 is a diagram illustrating the attenuation-frequency characteristics of a transmission filter of the duplexer used in the third embodiment and the transmission characteristics of an LC circuit.
Fig. 10 is a diagram illustrating the frequency characteristics of a transmission signal in a filter device of the third embodiment and the attenuation-frequency characteristics of a transmission filter of the duplexer to which the LC circuit is not connected.
Fig. 11(a) to Fig. 11(c) are circuit diagrams illustrating modifications of an LC circuit.

### Description of Embodiments

Hereinafter, specific embodiments of the present invention will be described with reference to the drawings, thereby clarifying the present invention.

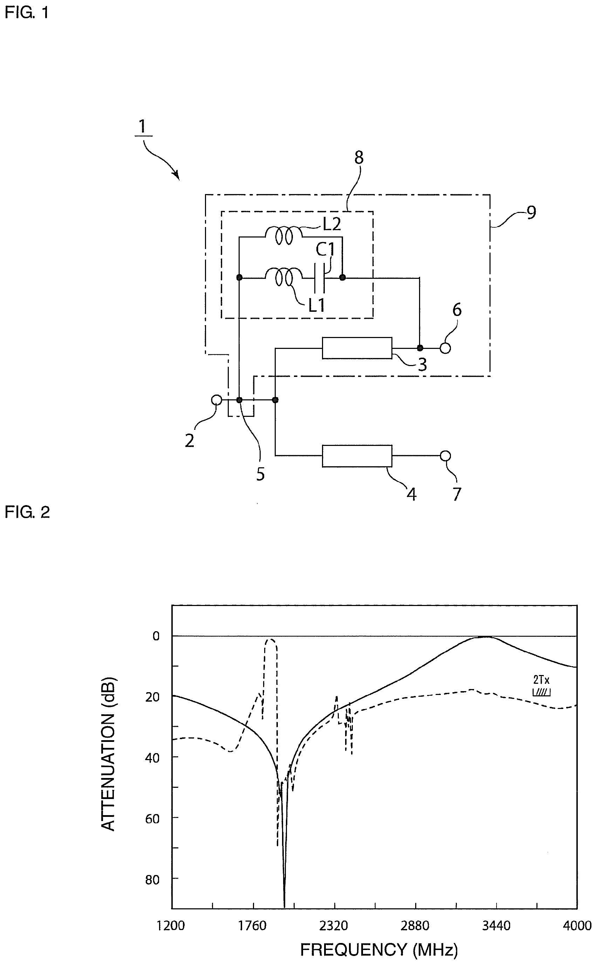

Fig. 1 is a schematic block diagram illustrating a duplexer including a filter device according to a first embodiment of the present invention.

A duplexer 1 is connected to an antenna of a cellular phone. The duplexer 1 includes an antenna terminal 2 to be connected to the antenna. A first band pass filter 3 forming a transmission filter and a second band pass filter 4 forming a reception filter are connected to the antenna terminal 2. The pass band of the first band pass filter 3 is a transmission band. The pass band of the second band pass filter 4 is a reception band and is different from the pass band of the first band pass filter 3.

The first band pass filter 3 described above is connected between a first signal terminal 5 and a second signal terminal 6. The second band pass filter 4 described above is connected between the first signal terminal 5 and a reception terminal 7.

A feature of the present embodiment is that an LC circuit 8 is connected in parallel with the first band pass filter 3, whereby a filter device 9 of the present embodiment is formed.

The LC circuit 8 includes an inductor L1 connected between the first signal terminal 5 and the second signal terminal 6. A capacitor C1 is connected in series with the inductor L1. Further, a second inductor L2 is connected in parallel with a circuit element in which the inductor L1 and the capacitor C1 are connected in series. The first inductor L1, the capacitor C1, and the second inductor L2 form the LC circuit 8. The LC circuit 8 is configured to make attenuation in a specified frequency band outside of the pass band of the first band pass filter 3 higher than in the case in which the LC circuit 8 is not connected.

The LC circuit 8 has anti-resonant characteristics that make the LC circuit 8 be open in the pass band of the first band pass filter 3.

Note that the anti-resonant characteristics that make the LC circuit 8 be open in the pass band of the first band pass filter 3 indicate that the pass band is positioned in the vicinity of the anti-resonant frequency. In this case, the anti-resonant frequency may be positioned outside of the pass band. In the vicinity of the anti-resonant frequency, the impedance of the LC circuit 8 is very high. Hence, when the pass band is positioned in the vicinity of the anti-resonant frequency, almost no current flows through the LC circuit 8. In other words, the LC circuit is in a state of being open. Accordingly, an increase in loss in the pass band can be avoided since almost no current flows through the LC circuit 8. That is, attenuation in a desired frequency band other than the pass band can be increased while maintaining the attenuation in the pass band of the first band pass filter sufficiently low, in accordance with the present invention, as described later.

Compared with the filter characteristics of the first band pass filter 3 alone, the attenuation in a specified frequency band outside of the pass band of the first band pass filter 3 is made high when the LC circuit 8 is connected to the first band pass filter 3. As a result, the attenuation in the specified frequency band outside of the pass band of the first band pass filter 3 can be increased. This will be described more specifically with reference to Fig. 2 to Fig. 4.

The duplexer 1 of the present embodiment is used in UMTS Band 2. In Band 2, the transmission frequency band is in the 1850 to 1910 MHz band, the reception frequency band is the 1930 to 1990 MHz band, and the frequency interval between the two bands is 80 MHz. The broken line in Fig. 2 illustrates the attenuation-frequency characteristics of the case in which the LC circuit 8 is not connected, i.e., the case of the first band pass filter 3 alone. As is clear from Fig. 2, the attenuation is made very low in the 1850 to 1910 MHz transmission frequency band. In the transmission filter of Band 2, high attenuation is required in a band of frequencies twice the transmission frequencies, i.e., 2 × (1850-1910) = 3700-3820 MHz. The reason for increasing the attenuation is to suppress inter-modulation distortion. With the attenuation-frequency characteristics illustrated by the broken line in Fig. 2, the attenuation in this pass band of frequencies which are twice those of the transmission band is not sufficiently high.

On the other hand, the solid line in Fig. 2 illustrates the transmission characteristics of the LC circuit 8 described above. As is clear from Fig. 2, the LC circuit 8 has a resonant frequency in the vicinity of 3370 MHz and anti-resonant frequency in the vicinity of 2000 MHz.

Hence, the LC circuit 8 has frequency characteristics that make the LC circuit 8 be open in the 1850-1910 MHz band, which is the pass band of the band pass filter 3. Accordingly, almost no current flows through the LC circuit 8 illustrated in Fig. 1 in the pass band of the first band pass filter 3, i.e., the transmission band.

Note that the LC circuit 8 can be formed in such a manner as to have resonant characteristics and anti-resonant characteristics illustrated by the solid line in Fig. 2 by adjusting the inductances of the first inductor L1 and the second inductor L2 and the capacitance of the capacitor C1 in accordance with the known specifications. A feature of the present embodiment is that the LC circuit 8 having such resonant and anti-resonant characteristics is connected in parallel with the first band pass filter 3.

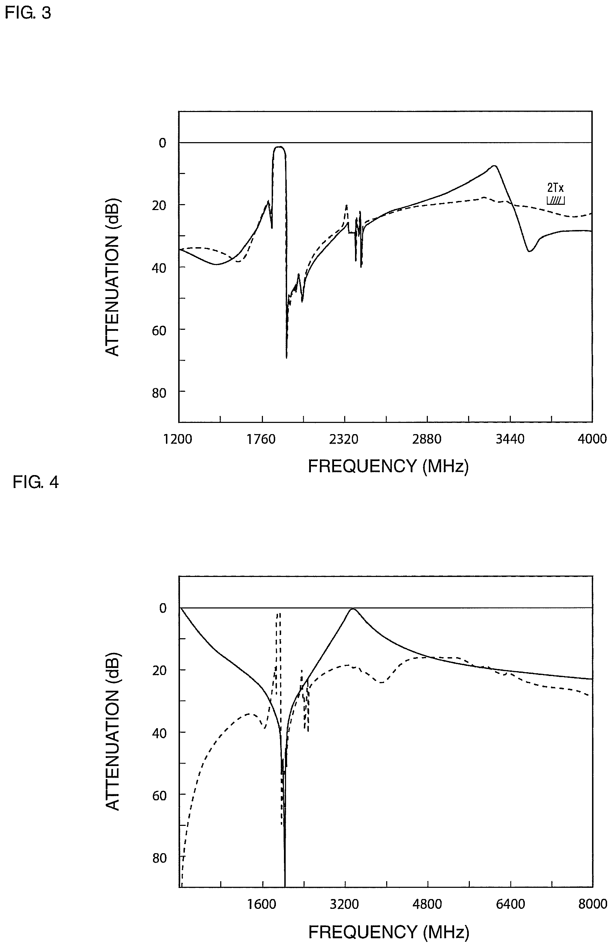

The solid line in Fig. 3 illustrates the attenuation-frequency characteristics of the filter device 9 described above, and the broken line illustrates the attenuation-frequency characteristics of the first band pass filter 3 alone, similarly to Fig. 2. Fig. 4 is a diagram illustrating the frequency characteristics of the attenuation in the transmission filter of the duplexer before connection of the LC circuit thereto and the transmission characteristics of the LC circuit, in the case where the measurement frequency band illustrated in Fig. 2 has been widened. In other words, Fig. 4 is a diagram illustrating the attenuation-frequency characteristics of the filter device 9, using a dashed line to show the frequency characteristics of the attenuation of the transmission filter 3 of the duplexer, together with a solid line showing the transmission characteristics of the LC circuit 8 in an overlapping manner.

A band denoted by 2Tx in Fig. 3 is a frequency band having frequencies twice the frequencies of the transmission frequency band. As is clear from the comparison of the solid line and the broken line in Fig. 3, in the filter device 9 of the present embodiment, the attenuation in the band 2Tx can be increased from about 23 dB to about 30 dB. Hence, according to the filter device 9 of the present embodiment, since the LC circuit 8 described above is configured to be able to increase attenuation in a specified frequency band outside of the pass band of the first band pass filter 3, i.e., in the band 2Tx, the attenuation of the filter device 9 in the band 2Tx can be increased.

In the band 2Tx described above, it is preferable that the amplitude and phase characteristics of the LC circuit 8 and the amplitude and phase characteristics of the band pass filter 3 have a relationship indicating the same amplitude but opposite phases. In other words, in the band 2Tx, it is preferable that the amplitude and phase characteristics of the LC circuit 8 and the amplitude and phase characteristics of the band pass filter have a complex conjugate relationship. In this case, as disclosed in Patent Document 1, the attenuation in a frequency band with the same amplitude with an opposite phase can be effectively increased.

Note that it is assumed that the term "the same amplitude" used above refers not only to the case in which the amplitudes of the two signals are exactly the same but also to the case in which the amplitude of one signal is within -3 dB to 2 dB of the amplitude of the other signal when compared on the basis of a log ratio. In other words, the two signals need not necessarily be exactly the same.

Further, it is assumed that the term "opposite phases" refers not only to the case in which the phases of two signals are exactly opposite but also to the case in which the phases are different from each other within the range of ±20 degrees. Even when the phases are different from each other within such a range, sufficiently high attenuation can be obtained at a desired frequency.

In the present embodiment, as described above, attenuation in the band 2Tx can be increased using the LC circuit 8. The LC circuit 8 does not need an active element. Hence, a control circuit for driving an active element can be omitted. Accordingly, reductions in size, cost, and power consumption can be realized while increasing attenuation outside of a band.

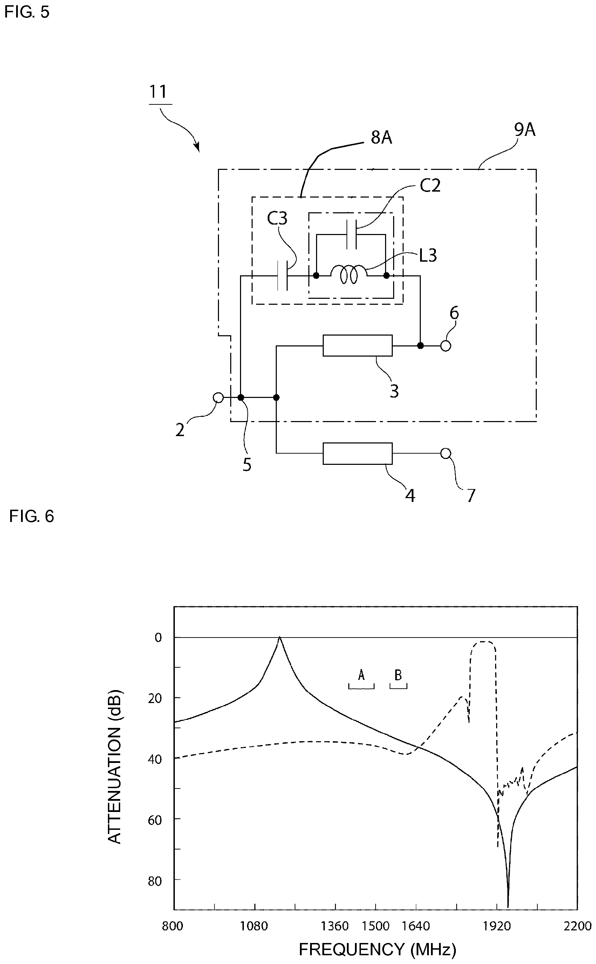

Fig. 5 is a schematic block diagram illustrating a duplexer including a filter device according to a second embodiment of the present invention. A duplexer 11 of the second embodiment performs transmission and reception of signals in UMTS Band 2, similarly to the duplexer 1 of the first embodiment. Similarly to the duplexer 1, the duplexer 11 includes the first signal terminal 5 connected to the antenna terminal 2. The first band pass filter 3 is connected between the first signal terminal 5 and the second signal terminal 6 as a transmission terminal. The second band pass filter 4 as a reception filter is connected between the first signal terminal 5 and the reception terminal 7. These configurations are the same as those of first embodiment. Unlike the first embodiment, an LC circuit 8A is used instead of the LC circuit 8 in the second embodiment. In other words, the LC circuit 8A is connected in parallel with the first band pass filter 3, whereby a filter device 9A of the second embodiment is formed.

The LC circuit 8A is connected in parallel with the first band pass filter 3 to increase attenuation in the vicinity of 1500 MHz, which is a pass band for a GPS signal. More specifically, the LC circuit 8A includes an inductor L3, a first capacitor C2, and a second capacitor C3. The self-resonant frequency of the inductor L3 is positioned in the vicinity of the pass band of the first band pass filter 3. The first capacitor C2 is connected in parallel with the inductor L3. As a result, an LC parallel resonant circuit is formed. Further, the second capacitor C3 is connected in series with the inductor L3.

The solid line in Fig. 6 illustrates the transmission characteristics of the LC circuit 8A and the broken line illustrates the attenuation-frequency characteristics of the first band pass filter 3. In other words, the broken line illustrates the attenuation-frequency characteristics of the first band pass filter 3 alone without connection of the LC circuit 8A. As is clear from the broken line in Fig. 6, the first band pass filter 3 has very low attenuation in the transmission band of Band 2 also in the present embodiment.

On the other hand, in the transmission characteristics of the LC circuit 8A, an anti-resonant frequency is positioned in the vicinity of the pass band of the first band pass filter 3, i.e., 1960 MHz. The resonant frequency is positioned near the vicinity of 1160 MHz. The frequency bands A and B in Fig. 6 illustrate frequency bands in which the attenuation of the filter device 9A is to be increased in the present embodiment. Specifically, the frequency band A is Band 11 and the frequency band B is the GPS transmission band. In a module device supporting a plurality of frequency bands, for example, in a module device that includes a GPS device and a filter supporting Band 11, noise needs to be suppressed in the GPS frequency band and the Band 11 frequency band. Hence, it is required that attenuation can be increased in a plurality of frequency bands.

In the present embodiment, in 1500 MHz, the inductance of the inductor L3 and the capacitances of the capacitors C2 and C3 are set in such a manner that a signal of the LC circuit 8A and a signal of the first band pass filter 3 have the same amplitude but opposite phases.

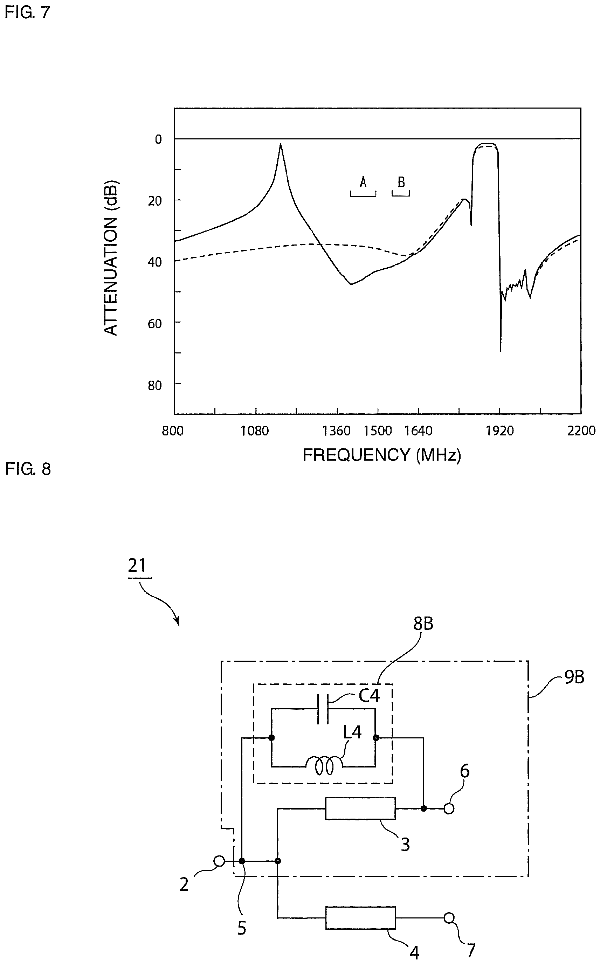

The broken line in Fig. 7 illustrates the attenuation-frequency characteristics of the above-described first band pass filter 3 alone and the solid line illustrates the attenuation-frequency characteristics of the filter device 9A. As is clear from Fig. 7, in a certain frequency band, the attenuation according to the present embodiment is increased to about 42-43 dB, while the attenuation is about 35 dB in the filter characteristics illustrated by the broken line corresponding to the case in which the LC circuit 8A is not connected.

In other words, also in the present embodiment, as a result of the LC circuit 8A having an anti-resonant frequency at a frequency outside of the pass band of the first band pass filter 3 and being connected to the first band pass filter 3, attenuation at specified frequencies outside of the pass band of the first band pass filter 3 can be increased.

Also in the present embodiment, the LC circuit 8A required to increase attenuation in the above described frequency band A and frequency band B, is formed of the inductor L3 and the capacitors C2 and C3. Hence, no active elements are required. Accordingly, reductions in size, cost, and power consumption can be realized, similarly to the first embodiment.

Fig. 8 is a schematic block diagram illustrating a duplexer according to a third embodiment of the present invention. Also in the present embodiment, similarly to the first embodiment, the first band pass filter 3 and the second band pass filter 4 are connected to the first signal terminal 5 which is connected to the antenna terminal 2. A duplexer 21 is also a duplexer that performs transmission and reception of UMTS Band 2.

Unlike the first embodiment, in the present embodiment, an LC circuit 8B is connected in parallel with the first band pass filter 3, whereby a filter 9B is formed.

The LC circuit 8B includes an inductor L4 and a capacitor C4 connected in parallel with the inductor L4. Hence, the LC circuit 8B is formed of a combination of two passive elements. Accordingly, reductions in size, cost, and power consumption compared with a phase and attenuation adjusting circuit using active elements such as a diode and an IC can be realized.

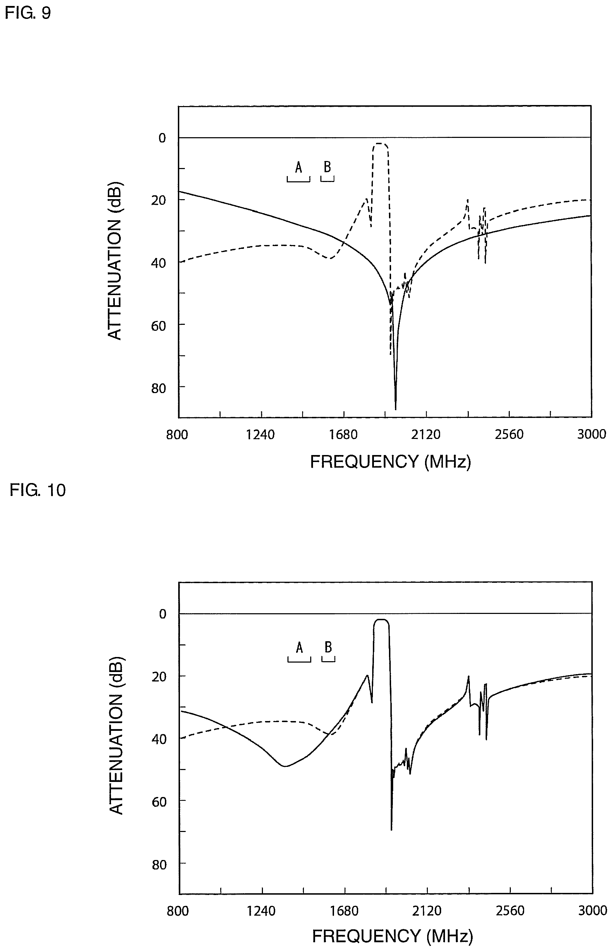

Also in the present embodiment, attenuation at 1500 MHz, which is a specified frequency outside of the pass band of the first band pass filter 3 is increased by connection of the LC circuit 8B. This will be described with reference to Fig. 9 and Fig. 10.

The broken line in Fig. 9 illustrates the attenuation-frequency characteristics of the first band pass filter 3 alone. The solid line illustrates the transmission characteristics of the LC circuit 8B. The LC circuit 8B, which is formed of the inductor L4 and the capacitor C4 connected in parallel with each other, does not have resonant characteristics and has only anti-resonant characteristics.

As is clear from Fig. 9, the anti-resonant frequency of the LC circuit 8B is positioned in the vicinity of 1840 MHz, i.e., positioned in the vicinity of and outside of the pass band of the first band pass filter 3. Hence, the LC circuit 8B is in an open state in the pass band of the first band pass filter 3. Accordingly, almost no current flows through the LC circuit 8B in the pass band of the first band pass filter 3. Hence, an increase in power consumption can be avoided.

The solid line in Fig. 10 illustrates the attenuation-frequency characteristics of the filter device 9B of the present embodiment, and the broken line illustrates the attenuation-frequency characteristics of the first band pass filter 3 alone. As is clear from Fig. 10, in the pass band for Band 11 and in a frequency band in the vicinity of the GPS frequency band, attenuation is significantly improved in accordance with the present embodiment. In other words, it can be seen that although the attenuation is about 35 dB with the first band pass filter 3 alone, the attenuation can be increased to about 42-44 dB in accordance with the present embodiment.

Also in the present embodiment, since the LC circuit 8B does not need an active element, reductions in cost, size, and power consumption can be realized.

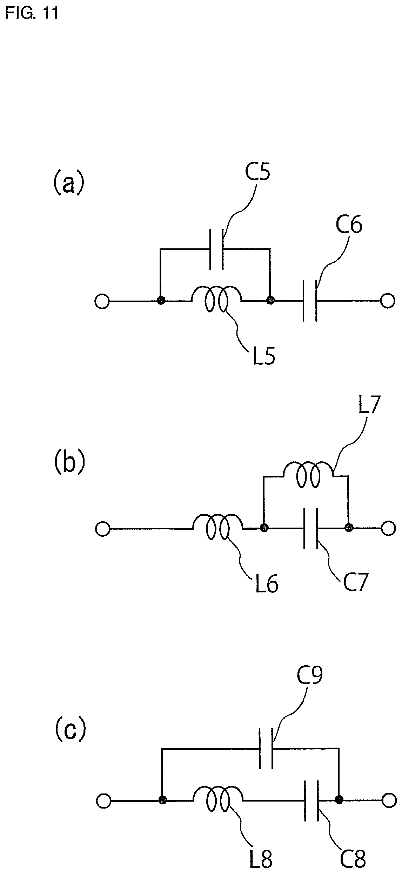

Note that the circuit configuration of the LC circuit in the present invention is not limited to the LC circuits 8, 8A, and 8B used in the first to third embodiments. Referring to Fig. 11(a), a configuration may be employed in which a capacitor C5 is connected in parallel with an inductor L5 and a capacitor C6 is connected in series with the inductor L5.

Referring to Fig. 11(b), a configuration may be employed in which a capacitor C7 is connected in series with an inductor L6 and an inductor L7 is connected in parallel with the capacitor C7.

Further, referring to Fig. 11(c), a configuration may be employed in which an inductor L8 and a capacitor C8 are connected in series and a capacitor C9 is connected in parallel with this circuit element in which the inductor L8 and the capacitor C8 are connected in series.

As is seen from the modifications of the LC circuit illustrated in Figs. 11(a)-11(c), the LC circuit in the present invention is not specifically limited as long as the LC circuit is configured to have an anti-resonant frequency that makes the LC circuit be open in the pass band of a band pass filter and configured to be able to increase attenuation in a specified frequency band outside of the pass band.

Further, although examples adapted to a transmission filter in UMTS Band 2 have been shown in the first to third embodiments described above, the present invention is not limited to these. For example, by connecting an LC circuit in parallel with the second band pass filter 4, which is a reception filter, attenuation outside of the pass band of the reception filter may be increased.

Further, the present invention can be used for increasing attenuation outside of pass bands in various bands other than Band 2 or in other communication systems.

According to the present invention, attenuation in a desired frequency band outside of the pass band of a band pass filter can be increased by connecting an LC circuit in parallel with the band pass filter as described above. Hence, attenuation outside of a band can be increased using an LC circuit regardless of a frequency region. For example, in a cellular phone in which the duplexer 1 and WRAN functionality are provided, when attenuation outside of the band of the duplexer 1 is to be increased in the WRAN pass band, the circuit constants of the LC circuit 8 can be adjusted so as to be able to increase the attenuation in the WRAN band.

### Reference Signs List

- 1: duplexer
- 2: antenna terminal
- 3: first band pass filter
- 4: second band pass filter
- 5: first signal terminal
- 6: second signal terminal
- 7: reception terminal
- 8, 8A, 8B LC: circuits
- 9, 9A, 9B: filter devices
- 11: duplexer
- 21: duplexer
- C1-C9: capacitors
- L1-L8: inductors

## Claims

1. A filter device (9) including first and second signal terminals (5,6), the filter device (9) comprising:
a band pass filter (3) connected between the first signal terminal (5) and the second signal terminal (6); and
an LC circuit (8) connected between the first signal terminal (5) and the second signal terminal (6), in parallel with the band pass filter (3), said LC circuit (8) comprising an inductor (L2/L3/L4/L5/L7/L8) and a capacitor (C1/C2/C4/C5/C7/C9) connected in parallel to one another;
wherein the LC circuit (8) is configured to have anti-resonant characteristics with the anti-resonant frequency positioned within or in the vicinity of a pass band of the band pass filter (3) so that almost no current flows through the LC circuit (8) in the pass band of the band pass filter (3), and configured to make attenuation in a specified frequency band outside of the pass band of the band pass filter (3) higher than in a case in which the LC circuit (8) is not connected, as a result of the LC circuit (8) being connected.

2. The filter device (9) according to Claim 1, wherein in the specified frequency band outside of the pass band of the band pass filter (3), the amplitude characteristics and phase characteristics of the LC circuit (8) and the amplitude characteristics and phase characteristics of the band pass filter (3) have a relationship indicating the same amplitude within -3dB to 2dB of each other when compared on the basis of a log ratio but opposite phases or a phase difference within ±20 degrees of each other.

3. The filter device (9) according to Claim 1 or 2, wherein said anti-resonant frequency of the LC circuit (8) is positioned within the pass band of the band pass filter (3).

4. The filter device (9) according to any one of Claims 1 to 3, wherein the LC circuit (8) is an LC circuit having a resonant frequency as well as said anti-resonant frequency.

5. The filter device (9B) according to any one of Claims 1 to 3, wherein the LC circuit (8B) does not have a resonant frequency.

6. A duplexer (1) including an antenna terminal (2) connected to an antenna, the duplexer (1) comprising:
a first filter device (9) formed of the filter device according to any one of Claims 1 to 5, with the first signal terminal (5) being electrically connected to the antenna terminal (2); and
a second filter device (4) that is connected to the antenna terminal (2) and that has a pass band different from the pass band of the first filter device (3).

7. A duplexer (1) including an antenna terminal (2) connected to an antenna, the duplexer (1) comprising:
a first filter device (9) formed of the filter device according to any one of Claims 1 or 2, or any one of Claims 4 or 5 when dependent on Claim 1 or 2, with the first signal terminal (5) being electrically connected to the antenna terminal (2); and
a second filter device (4) that is connected to the antenna terminal (2) and that has a pass band different from the pass band of the first filter device (3);
wherein an anti-resonant frequency of the LC circuit (8) in the first filter device (9) is positioned between the pass band of the first filter device (9) and the pass band of the second filter device (4).

8. The duplexer according to Claim 6 or 7, wherein the first filter device (9) is a transmission filter and the second filter device (4) is a reception filter.

## Patentansprüche

1. Filtervorrichtung (9), die einen ersten und einen zweiten Signalanschluss (5, 6) enthält, wobei die Filtervorrichtung (9) umfasst:
ein Bandpassfilter (3), das zwischen den ersten Signalanschluss (5) und den zweiten Signalanschluss (6) geschaltet ist, und
einen LC-Schaltkreis (8), der zwischen den ersten Signalanschluss (5) und den zweiten Signalanschluss (6) parallel zu dem Bandpassfilter (3) geschaltet ist, wobei der LC-Schaltkreis (8) eine Induktionsspule (L2/L3/L4/L5/L7/L8) und einen Kondensator (C1/C2/C4/C5/C7/C9) umfasst, die zueinander parallel geschaltet sind,
wobei der LC-Schaltkreis (8) dafür konfiguriert ist, Antiresonanzeigenschaften zu besitzen, wobei die Antiresonanzfrequenz innerhalb oder in der Nähe eines Durchlassbandes des Bandpassfilters (3) positioniert ist, so dass fast kein Strom durch den LC-Schaltkreis (8) in dem Durchlassband des Bandpassfilters (3) fließt, und dafür konfiguriert ist, in einem spezifizierten Frequenzband außerhalb des Durchlassbandes des Bandpassfilters (3) eine stärkere Dämpfung zu realisieren als in einem Fall, in dem der LC-Schaltkreis (8) nicht verbunden ist, nachdem der LC-Schaltkreis (8) verbunden wurde.

2. Filtervorrichtung (9) nach Anspruch 1, wobei in dem spezifizierten Frequenzband außerhalb des Durchlassbandes des Bandpassfilters (3) die Amplitudeneigenschaften und Phaseneigenschaften des LC-Schaltkreises (8) und die Amplitudeneigenschaften und Phaseneigenschaften des Bandpassfilters (3) eine Beziehung haben, die die gleiche Amplitude innerhalb von -3dB bis 2dB voneinander anzeigt, wenn sie auf Basis eines log-Verhältnis verglichen werden, aber entgegengesetzte Phasen oder eine Phasendifferenz innerhalb von ±20 Grad zueinander haben.

3. Filtervorrichtung (9) nach Anspruch 1 oder 2, wobei die Antiresonanzfrequenz des LC-Schaltkreises (8) innerhalb des Durchlassbandes des Bandpassfilters (3) positioniert ist.

4. Filtervorrichtung (9) nach einem der Ansprüche 1 bis 3, wobei der LC-Schaltkreis (8) ein LC-Schaltkreis ist, der eine Resonanzfrequenz sowie die Antiresonanzfrequenz aufweist.

5. Filtervorrichtung (9B) nach einem der Ansprüche 1 bis 3, wobei der LC-Schaltkreis (8B) keine Resonanzfrequenz hat.

6. Duplexer (1), der einen Antennenanschluss (2) enthält, der mit einer Antenne verbunden ist, wobei der Duplexer (1) umfasst:
eine erste Filtervorrichtung (9), die aus der Filtervorrichtung nach einem der Ansprüche 1 bis 5 besteht, wobei der erste Signalanschluss (5) elektrisch mit dem Antennenanschluss (2) verbunden ist, und
eine zweite Filtervorrichtung (4), die mit dem Antennenanschluss (2) verbunden ist und deren Durchlassband ein anderes ist als das Durchlassband der ersten Filtervorrichtung (3).

7. Duplexer (1), der einen Antennenanschluss (2) enthält, der mit einer Antenne verbunden ist, wobei der Duplexer (1) umfasst:
eine erste Filtervorrichtung (9), die aus der Filtervorrichtung nach einem der Ansprüche 1 und 2 oder nach einem der Ansprüche 4 und 5, wenn von Anspruch 1 oder 2 abhängig, besteht, wobei der erste Signalanschluss (5) elektrisch mit dem Antennenanschluss (2) verbunden ist, und
eine zweite Filtervorrichtung (4), die mit dem Antennenanschluss (2) verbunden ist und deren Durchlassband ein anderes ist als das Durchlassband der ersten Filtervorrichtung (3),
wobei eine Antiresonanzfrequenz des LC-Schaltkreises (8) in der ersten Filtervorrichtung (9) zwischen dem Durchlassband der ersten Filtervorrichtung (9) und dem Durchlassband der zweiten Filtervorrichtung (4) positioniert ist.

8. Duplexer nach Anspruch 6 oder 7, wobei die erste Filtervorrichtung (9) ein Sendefilter ist und die zweite Filtervorrichtung (4) ein Empfangsfilter ist.

## Revendications

1. Dispositif de filtre (9) comportant des première et seconde bornes de signaux (5, 6), le dispositif de filtre (9) comprenant :
un filtre passe-bande (3) connecté entre la première borne de signaux (5) et la seconde borne de signaux (6) ; et
un circuit LC (8) connecté entre la première borne de signaux (5) et la seconde borne de signaux (6), en parallèle avec le filtre passe-bande (3), ledit circuit LC (8) comprenant un inducteur (L2/L3/L4/L5/L7/L8) et un condensateur (C1/C2/C4/C5/C7/C9) connectés en parallèle l'un à l'autre ;
dans lequel le circuit LC (8) est configuré pour avoir des caractéristiques d'antirésonnance avec la fréquence d'antirésonnance positionnée au sein ou au voisinage d'une bande passante du filtre passe-bande (3) de sorte que presqu'aucun courant ne passe à travers le circuit LC (8) dans la bande passante du filtre passe-bande (3), et configuré pour réaliser une atténuation dans une bande de fréquence spécifiée à l'extérieur de la bande passante du filtre passe-bande (3) plus élevée que dans un cas dans lequel le circuit LC (8) n'est pas connecté, en conséquence de la connexion du circuit LC (8).

2. Dispositif de filtre (9) selon la revendication 1, dans lequel dans la bande de fréquence spécifiée à l'extérieur de la bande passante du filtre passe-bande (3), les caractéristiques d'amplitude et caractéristiques de phase du circuit LC (8) et les caractéristiques d'amplitude et caractéristiques de phase du filtre passe-bande (3) ont une relation indiquant la même amplitude dans les -3dB à 2dB l'une de l'autre lors d'une comparaison réalisée sur la base d'un rapport logarithmique mais des phases opposées ou une différence de phase dans les ± 20 degrés l'une de l'autre.

3. Dispositif de filtre (9) selon la revendication 1 ou 2, dans lequel ladite fréquence d'antirésonnance du circuit LC (8) est positionnée au sein de la bande passante du filtre passe-bande (3).

4. Dispositif de filtre (9) selon l'une quelconque des revendications 1 à 3, dans lequel le circuit LC (8) est un circuit LC ayant une fréquence de résonnance ainsi que ladite fréquence d'antirésonnance.

5. Dispositif de filtre (9B) selon l'une quelconque des revendications 1 à 3, dans lequel le circuit LC (8B) n'a pas de fréquence de résonnance.

6. Duplexeur (1) comportant une borne d'antenne (2) connectée à une antenne, le duplexeur (1) comprenant :
un premier dispositif de filtre (9) formé du dispositif de filtre selon l'une quelconque des revendications 1 à 5, avec la première borne de signaux (5) connectée électriquement à la borne d'antenne (2) ; et
un second dispositif de filtre (4) qui est connecté à la borne d'antenne (2) et qui a une bande passante différente de la bande passante du premier dispositif de filtre (3).

7. Duplexeur (1) comportant une borne d'antenne (2) connectée à une antenne, le duplexeur (1) comprenant :
un premier dispositif de filtre (9) formé du dispositif de filtre selon l'une quelconque des revendications 1 ou 2, ou n'importe laquelle des revendications 4 ou 5 lorsqu'elles dépendent de la revendication 1 ou 2, avec la première borne de signaux (5) connectée électriquement à la borne d'antenne (2) ; et
un second dispositif de filtre (4) qui est connecté à la borne d'antenne (2) et qui a une bande passante différente de la bande passante du premier dispositif de filtre (3) ;
dans lequel une fréquence d'antirésonnance du circuit LC (8) dans le premier dispositif de filtre (9) est positionnée entre la bande passante du premier dispositif de filtre (9) et la bande passante du second dispositif de filtre (4).

8. Duplexeur selon la revendication 6 ou 7, dans lequel le premier dispositif de filtre (9) est un filtre de transmission et le second dispositif de filtre (4) est un filtre de réception.
